# EUROPEAN PATENT APPLICATION

(11) **EP 1 337 007 A1**
(43) Date of publication of application: **20.08.2003**
(21) Application number: 02445025.6
(22) Date of filing: 18.02.2002
(51) Int. Cl.: H01R 12/22

(54) **Intermediate board**

(71) Applicant: Sony Ericsson Mobile Communications AB, 221 88 Lund (SE)
(72) Inventor: Bygdö, Haakan, 226 54 Lund (SE)
(74) Representative: Akerman, Marten Lennart

(57) **Abstract**

The invention relates to an intermediate board and more particularly to a device adapting the footprint of a component to a contact arrangement of a support, e.g. a printed circuit board to which the component is to be connected. The device (3) is on one side adapted to make contact with the component (1') and on the other side adapted to make contact with the support (2). The component (1') may be a memory circuit to be connected to an electronic equipment for use in a mobile telephone and similar. The invention also relates to methods for testing components by means of the device and developing and adapting circuit boards for use with different components.

## Description

### Field of the invention

The present invention relates to an intermediate board and more particularly to a device adapting the footprint of a component to a contact arrangement of a main printed circuit board to which the component is to be connected. The component may be a memory circuit to be connected to an electronic equipment for use in a mobile telephone and similar. The invention also relates to methods for testing components by means of the device and developing and adapting circuit boards for use with different components.

### State of the art

It is previously known to use adapter boards in test devices.

US A 5,109,596 describes a contact arrangement for the connection of contact points of a circuit board to the electrical contact points of a test device. This includes an adapter board having a plurality of metal contact points arranged on each side thereof. At least one side of the adapter board and at least one cushion-like plug is made from an electrically conductive springy elastomer.

US A 5,399,982 describes an adapter for electrical connection between test points on a circuit board and contacts on the basic printed circuit board. The adapter has a flexible foil that carries a footprint on one side and a different footprint on the other side. The contact points are electrically interconnected on both sides of the adapter foil by plated-through holes.

These documents do not relate to the connection of components to a main board incorporated in general electronic equipment, but only in test devices. The documents mainly relate to perfecting the electric contact between a circuit to be tested and the test device, accommodating varying heights and lateral displacements.

### Summary of the invention

In equipment using a main circuit board for connecting circuits the layout of contact arrangements has to be customized to one specific circuit with a specific footprint or contact arrangement. In the early development phase and during prototype testing, it is desired to be able to test circuits with different footprints, e.g. from different providers. Also, when a product is finished using a circuit with a specific footprint, it may be desired to switch to another circuit having another footprint. This may be for many reasons, e.g. it is desired to switch to a circuit having better capacity, or the original circuit provider has changed the circuit or it is desired to switch circuit for business related reasons.

The present invention solves e.g. the above-mentioned problems by providing a device for interconnecting a component-carrying support and a component.

In accordance with one aspect of the invention, there is provided a device for interconnecting a component-carrying support and a component, characterised in that the device on one side is adapted to make contact with the component and on the other side is adapted to make contact with the support.

In accordance with a further aspect of the invention, there is provided a component suitable for connection to a component-carrying support, characterised in that the component is secured to a device, said device on one side being adapted to make contact with the component and on the other side being adapted to make contact with the support.

The component may comprise a memory circuit.

In accordance with a further aspect of the invention, there is provided an electronic equipment comprising at least one component-carrying support and at least one component, characterised in that the component is secured to a device, said device on one side being adapted to make contact with the component and on the other side being adapted to make contact with the support.

The electronic equipment may be comprised in a mobile telephone or in a test device for testing components.

In accordance with a further aspect of the invention, there is provided a component-carrying support, characterised in that the component-carrying support is provided with a contact arrangement enabling connection with a range of components having different contact arrangements by means of a device, said device on one side being adapted to make contact with a respective component and on the other side being adapted to make contact with the support.

The component-carrying support may be a circuit board prepared for connection of memory circuits having different capacities and contact arrangements.

In accordance with a further aspect of the invention, there is provided a method of testing a component suitable for connection to a component-carrying support, characterised by the steps of:
connecting the component to a device, said device on one side being adapted to make contact with the component and on the other side being adapted to make contact with the support;
connecting the device to the support; and
running a test with the component thus connected to the support.

In accordance with a further aspect of the invention, there is provided a method of adaptation of a component to a component-carrying support, characterised by the steps of:
connecting the component to a device, said device on one side being adapted to make contact with the component and on the other side being adapted to make contact with the support in accordance with their respective contact arrangements; and
connecting the device to the support.

In accordance with a further aspect of the invention, there is provided a method of adaptation of a component-carrying support to a second component having a different contact arrangement than a first component, characterised by the steps of:
connecting the second component to a device, said device on one side being adapted to make contact with the second component and on the other side being adapted to make contact with the support in accordance with their respective contact arrangements; and
connecting the device to the support.

The component-carrying support may be provided with a contact arrangement enabling connection with a range of components having different contact arrangements.

The second component may comprise more than one circuit.

The invention provides several advantages. The main circuit board does not have to be re-designed in order to connect a component having a different footprint from which it was originally designed for. This facilitates testing different components. It is also easy to switch components during the normal production of the product or when products need repair or upgrading.

### Brief description of the drawings

The invention will be described in detail below with reference to the accompanying drawings, in which:
fig. 1 is a schematic cross-sectional view of a circuit board having a component mounted thereon without using an intermediate board according to the present invention,
fig. 2 is a schematic cross-sectional view showing the connection of a component to a circuit board through an intermediate board according to the present invention, and
fig. 3 is a detail view of an exemplifying intermediate board.

### Detailed description of preferred embodiments

The present invention may be used e.g. in a mobile telephone, or other electronic device, comprising electronic equipment including a printed circuit board having mounted thereon various circuits. One circuit may e.g. be a memory circuit.

The following terms are used in the application and should have the following meanings and equivalents thereof. The main board is a component-carrying support or structure including electrical connections and conducting surfaces as is conventional in the printed circuit board technology. A component can be any electric circuit or device connected to the main board, e.g. memory circuits or other integrated circuits or discrete components. The footprint of a component refers to the layout or arrangement of contacting points or surfaces arranged for contacting e.g. a circuit board. The actual terminals may be contact surfaces or protruding pads or pins.

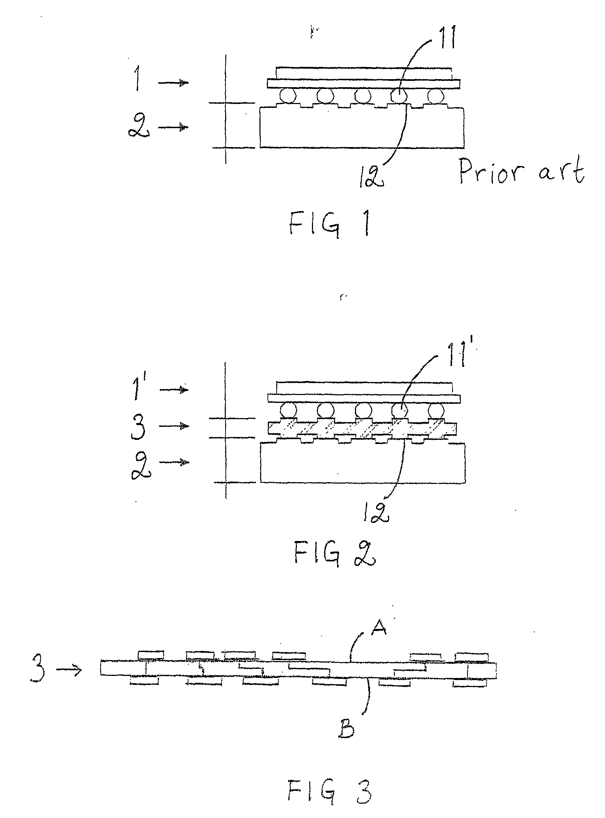

In fig. 1 is shown the initial arrangement of a component 1 and main board 2. The component has a fixed contact arrangement 11. When designing the board 2 it is provided with corresponding contact arrangement 12. The main board forms part of an electronic equipment to be fitted in a product by a manufacturer. The components 1 are often supplied by a subcontractor. During the development of the product there may be a lot of subcontractors to choose from and also each subcontractor may have different models of the component performing the same or a similar function, but all these components do not generally have the same footprint but may vary. Thus, if the manufacturer of the product wants to test different components he has to design and build a main board with a specific layout of the contact arrangement customized for each component to be tested.

The present invention solves this problem by providing an intermediate board that acts as an adapter between a component and a main board. As is shown in fig. 2, the intermediate board 3 is placed between the component 1 and the main board 2. The intermediate board 3 is attached by soldering to the component 1' and the main board 2, respectively, in a suitable order. The component 1' has a different contact arrangement 11' from the original component 1. The intermediate board 3 acts to translate the footprint 11' so that it fits with the contact arrangement 12 of the original main board 2.

Fig. 3 shows a detail view of the intermediate board 3. One side A has a contact arrangement fitting with the component 1', while the opposite side B has a contact arrangement fitting with the main board 2. The intermediate board comprises layers of conducting and isolating materials with connections between conducting surfaces on the opposite sides A and B. The intermediate board may be produced by means of conventional technology.

Thus, instead of having to produce a customized main board for each component footprint the manufacturer only needs to produce an intermediate board for each specific component. The size of the intermediate board is adapted to the component and is of course much smaller than the whole main board. Only part of the main board is shown in the drawings.

When the testing is done, the manufacturer of the complete product decides to select one of the components tested. Then he will probably customize a main board to the selected component. However, it is also possible to keep the original main board and to use the component with the intermediate board permanently in the finished product. The intermediate board only adds a certain height to the component, e.g. less than one millimetre, which has to be taken into account when designing the housing covering the equipment.

The provider of the component may also wish to add the intermediate board directly in this own factory so that the component is delivered with the intermediate board attached to the component permanently, e.g. by soldering. In this way the provider of the component may sell the same component but with different footprints adapted to different main boards.

It may be that the manufacturer of the product wants to change to another component later. This may be because the agreement with the original provider of the component has ceased, a new model of the component with better capacity has arrived on the market or for various other reasons. In this case, the production of the product needs only be changed in as much as a specific intermediate board is produced which fits the new component to the original main board.

The intermediate board may also be used to up-grade a product. For instance memory circuits with larger capacity may be used to replace the original circuit in a mobile telephone by means of the intermediate board. Moreover, since newer memory circuits tend to be smaller in dimensions than older ones it may be possible to fit in two new memory circuits replacing one old by means of an intermediate board having the required contact arrangement.

Already when designing the original main board this may be designed with electric connections for addressing a memory circuit that in fact is not yet in the market. By means of a customized intermediate board only those connections are used initially that are needed for the memory circuit available at the moment. When new models of the memory circuit arrive the main board is already prepared and the new memory circuits are connected to the main board by means of another intermediate board so that all the required connections are used.

The intermediate board may also be used in electronic equipment comprised in a test device for testing components. A specific intermediate board is designed and used for each component to be tested (except components compatible directly with the test device).

It will be appreciated that the invention is useful for adapting circuit boards of electronic equipment to various components and in many applications. The term electronic equipment includes e.g. portable radio communication equipment. The term portable radio communication equipment includes all equipment such as mobile telephones, pagers, communicators, electronic organizers, smart phones and the like.

## Claims

1. Device for interconnecting a component-carrying support (2) and a component (1'), **characterised in that** the device (3) on one side (A) is adapted to make contact with the component (1') and on the other side (B) is adapted to make contact with the support (2).

2. Device according to claim 1, **characterised in that** the device (3) on one side (A) is provided with a contact arrangement to make contact with the component (1') and on the other side is provided with a contact arrangement (B) to make contact with the support (2).

3. Device for interconnecting a component-carrying support and a component, **characterised in that** it includes means for translating a contact arrangement (11') of the component (1') to a contact arrangement (12) of the support (2).

4. Component suitable for connection to a component-carrying support, **characterised in that** the component (1') is secured to a device (3), said device (3) on one side (A) being adapted to make contact with the component (1') and on the other side (B) being adapted to make contact with the support (2).

5. Component according to claim 4, **characterised in that** the component (1') is secured by soldering to the device (2).

6. Component according to claim 4 or 5, **characterised in that** it comprises a memory circuit.

7. Electronic equipment comprising at least one component-carrying support (2) and at least one component (1'), **characterised in that** the component (1') is secured to a device (3), said device (3) on one side (A) being adapted to make contact with the component (1') and on the other side (B) being adapted to make contact with the support (2).

8. Electronic equipment according to claim 7, **characterised in that** the component-carrying support (2) is a circuit board.

9. Electronic equipment according to claim 8, **characterised in that** the component (1') comprises a memory circuit.

10. Electronic equipment according to any of claims 7 to 9, **characterised in that** electronic equipment is comprised in a mobile telephone.

11. Electronic equipment according to any of claims 7 to 9, **characterised in that** electronic equipment is comprised in a test device for testing components.

12. Component-carrying support, **characterised in that** the component-carrying support (2) is provided with a contact arrangement (12) enabling connection with a range of components having different contact arrangements by means of a device, said device (3) on one side (A) being adapted to make contact with a respective component (1') and on the other side (B) being adapted to make contact with the support (2).

13. Component-carrying support according to claim 12, **characterised in that** the component-carrying support (2) is a circuit board prepared for connection of memory circuits having different capacities and contact arrangements.

14. Method of testing a component suitable for connection to a component-carrying support, **characterised by** the steps of:
connecting the component (1') to a device (3), said device (3) on one side (A) being adapted to make contact with the component (1') and on the other side (B) being adapted to make contact with the support (2);
connecting the device (3) to the support (2); and
running a test with the component (1') thus connected to the support (2).

15. Method of adaptation of a component to a component-carrying support, **characterised by** the steps of:
connecting the component (1') to a device (3), said device (3) on one side (A) being adapted to make contact with the component (1') and on the other side (B) being adapted to make contact with the support (2) in accordance with their respective contact arrangements (11', 12); and
connecting the device (3) to the support (2).

16. Method of adaptation of a component-carrying support to a second component having a different contact arrangement than a first component, **characterised by** the steps of:
connecting the second component (1') to a device (3), said (3) device on one side being adapted to make contact with the second component (1') and on the other side being adapted to make contact with the support (2) in accordance with their respective contact arrangements (12, 11'); and
connecting the device (3) to the support (2).

17. Method of adaptation according to claim 15 or 16, **characterised in that** the component-carrying support (2) is provided with a contact arrangement (12) enabling connection with a range of components (1') having different contact arrangements (11').

18. Method of adaptation according to claim 16 or 17, **characterised in that** the second component has better performance than the first component.

19. Method of adaptation according to claim 16, 17 or 18, **characterised in that** the second component comprises more than one circuit.
